# EUROPÄISCHE PATENTSCHRIFT

(11) **EP 1 070 352 B1**
(45) Veröffentlichungstag und Bekanntmachung des Hinweises auf die Patenterteilung: **13.08.2008**
(21) Anmeldenummer: 99924679.6
(22) Anmeldetag: 25.03.1999
(51) Int. Cl.: H01L 27/112, H01L 21/8246

(54) **HALBLEITER-SPEICHERVORRICHTUNG UND VERFAHREN ZU DEREN HERSTELLUNG**
SEMICONDUCTOR MEMORY AND METHOD FOR PRODUCING SAME
MEMOIRE A SEMICONDUCTEURS ET SON PROCEDE DE PRODUCTION

(30) Priorität: 08.04.1998 DE 19815874
(43) Veröffentlichungstag der Anmeldung: 24.01.2001
(73) Patentinhaber: Infineon Technologies AG, 81669 München (DE)
(72) Erfinder: RUSCH, Andreas, D-01099 Dresden (DE); ROTHENHÄUSSER, Steffen, D-01099 Dresden (DE); TRÜBY, Alexander, D-01099 Dresden (DE); OTANI, Yoichi, D-01478 Weixdorf (DE); ZIMMERMANN, Ulrich, Mechanicsville, VA 23116 (US)
(74) Vertreter: Reinhard - Skuhra - Weise & Partner
(86) Internationale Anmeldenummer: PCT/DE1999/000901
(87) Internationale Veröffentlichungsnummer: WO 1999/053546

(56) Entgegenhaltungen:
- DE-A- 4 008 883
- US-A- 5 621 247
- PATENT ABSTRACTS OF JAPAN vol. 008, no. 173 (E-259), 9. August 1984 (1984-08-09) & JP 59 067666 A (MITSUBISHI DENKI KK), 17. April 1984 (1984-04-17)

## Beschreibung

Die vorliegende Erfindung betrifft eine Halbleiter-Speichervorrichtung und eine Verfahren zu deren Herstellung.

Offenbart in der DE 40 08 833 A ist ein Verfahren zur Herstellung eines Masken-ROMs mit einem Feld von Speicherzellen, bei dem pn-Übergänge, die durch Einlagern von P-Störstellen mittels Ionenimplantation in die Oberfläche elektrisch leitender Schichten vom N-Typ, die wiederum durch Einlagern von N-Störstellen in Polysiliziumschichten erhalten worden ist, geschaffen werden, als Speicherzellen in einer Matrixkonfiguration gebildet sind.

Die JP 59 067666 A offenbart einen Nurlesespeicher, bei dem pn-Übergänge, die mit Kontaktlöchern als Maske erzeugt wurden, als Speicherzellen verwendet werden.

Die US-A-5 621 247 offenbart eine Speichervorrichtung mit Speicherzellen, die jeweils aus einer Wolframelektrode und einer siliziumhaltigen Aluminiumlegierungselektrode bestehen. Fließt durch eine Speicherzelle ein großer Strom, so bewegt sich Silizium in der Aluminiumlegierungselektrode entgegen der Stromflussrichtung und wird in der Aluminiumlegierungselektrode in der Nähe der Grenzfläche mit der Wolframelektrode abgeschieden, was zu einem erhöhten Widerstandswert führt. Daten können gelesen werden, indem mit einem äußerst kleinen Strom die Größe des Widerstandswerts gemessen und beurteilt wird, ob dieser sich in einem hohen oder niedrigen Zustand befindet.

Obwohl prinzipiell auf beliebige Halbleiter-Speichervorrichtungen anwendbar, werden die vorliegende Erfindung sowie die ihr zugrundeliegende Problematik in Bezug auf ROM-Speicher bzw. Nurlesespeicher in Siliziumtechnologie erläutert.

Bekannte ROM-Halbleiter-Speichervorrichtungen dieser Art verwenden horizontale oder vertikale MOSFETs als Halbleiterspeicherzellen. Eine gängige Methode zur Programmierung solcher ROM-Speicher besteht darin, die Einsatzspannungen der im ROM Zellenfeld verwendeten MOSFETs entsprechend des gewünschten ROM-Inhalts durch geeignet maskierte vertikale Kanalimplantationen zu modifizieren. Mit anderen Worten schafft man mindestens zwei Typen von MOSFETs, einen ersten Typ mit einer ersten Einsatzspannung (z.B. ohne Kanalimplantation) und einen zweiten Typ mit einer zweiten Einsatzspannung (z.B. mit Kanalimplantation). Dem einen Typ wird die logische "1" zugeordnet und dem anderen Typ die logische "0". Derart programmiert kann jeder Transistor ein einziges Bit speichern.

Einständiges Ziel bei der Speicherentwicklung ist die Erhöhung der Speicherdichte, d.h. der Anzahl von Bits, welche pro Flächeneinheit bzw. Volumeneinheit speicherbar sind. Ein Ansatz in dieser Richtung ist die stetige Verkleinerung der beteiligten Strukturen, beispielsweise durch ROM-Speicher mit gefalteten Grabenstrukturen.

Ein weiterer Ansatz besteht darin, dass die Halbleiterspeicherelemente derart zu modifizieren, dass sie jeweils mehr als ein Bit speichern können. Dies lässt sich beispielsweise da durch erreichen, dass man mehr als einen Typ von Kanalimplantation durchführt, so dass für jede Kanalimplantation ein Bit pro Speicherzelle speicherbar ist.

Beispielsweise können mit vier verschiedenen Kanalimplantationen vier verschiedene Einsatzspannungen, also 2 Bits pro Speicherzelle, erzeugt werden. Mit einer geeigneten Ausleseschaltung können die verschiedenen Einsatzspannungen unterschieden werden.

Die Aufgabe der vorliegenden Erfindung besteht darin, eine vereinfachte Halbleiter-Speichervorrichtung, deren Halbleiterspeicherelemente mehr als ein Bit speichern können, und ein Verfahren zu deren Herstellung anzugeben.

Erfindungsgemäß wird diese Aufgabe durch die in Anspruch 1 angegebene Halbleiter-Speichervorrichtung und das in Anspruch 2 angegebene Herstellungsverfahren gelöst.

Die der vorliegenden Erfindung zugrundeliegende Idee besteht darin, dass der jeweilige Bitfestlegungsbereich derart gestaltet ist, dass er den Kontaktwiderstand zwischen dem Substratbereich und dem Kontaktstöpselbereich entsprechend dem in dem jeweiligen Halbleiterspeicherelement zu speichernden Bit festlegt. Mit anderen Worten wird die Kontaktlochimplantationsmaske zur Programmierung verwendet, wobei die Kontaktlöcher mit einem unterschiedlichen Kontaktwiderstand versehen werden. Die verschiedenen Widerstände können dann beim Auslesen durch eine geeignete Auswerteschaltung bewertet werden. Die Auswerteschaltung kann eine Widerstandsmesseinrichtung aufweisen, kann aber auch kapazitiv oder induktiv arbeiten.

Die erfindungsgemäße Halbleiter-Speichervorrichtung und das erfindungsgemäße Verfahren zu deren Herstellung weisen gegenüber den bekannten Lösungsansätzen u.a. folgende Vorteile auf. Es kann mit nur zwei Implantationen eine dreiwertige Logik pro Speicherzelle realisiert werden. Das bedeutet, dass z.B. in zwei Zellen drei Bits gespeichert werden können. Dies erspart eine Maskenebene im vergleich zum oben beschriebenen bei MOSFETs üblichen Verfahren. Die Programmierung findet erst spät im Prozess nach der Kontaktlochätzung statt, was eine günstige Turn-around-time ermöglicht. Bei sicherheitsrelevanten Anwendungen, wie z.B. im Chipkartenbereich ist ein nachträgliches Auslesen durch Rückpräparation nur schwer möglich.

Schließlich sind keine zusätzlichen Schritte im Prozessablauf notwendig, denn viele bekannte Gesamtprozesse weisen Kontaktlochimplantationen auf, um den widerstand der Kontakte auf Diffusionsgebiet zu senken, und zwar insbesondere dann, wenn kein Titansilizid oder ähnliches verwendet wird. Das macht die erfindungsgemäße Halbleiter-Speichervorrichtung und das erfindungsgemäße Verfahren zu deren Herstellung sehr kostengünstig.

Ein Ausführungsbeispiel der Erfindung ist in den Zeichnungen dargestellt und in der nachfolgenden Beschreibung näher erläutert.

Es zeigen:
- Fig.1: eine schematische Darstellung eines Herstellungsschritts eines Halbleiterspeicherelements der Halbleiter-Speichervorrichtung gemäß einer ersten Ausführungsform der vorliegenden Erfindung; und
- Fig. 2: eine schematische Darstellung eines weiteren Herstellungsschritts des Halbleiterspeicherelements der Halbleiter-Speichervorrichtung gemäß der ersten Ausführungsform der vorliegenden Erfindung.

In den Figuren bezeichnen gleiche Bezugszeichen gleiche oder funktionsgleiche Bestandteile.

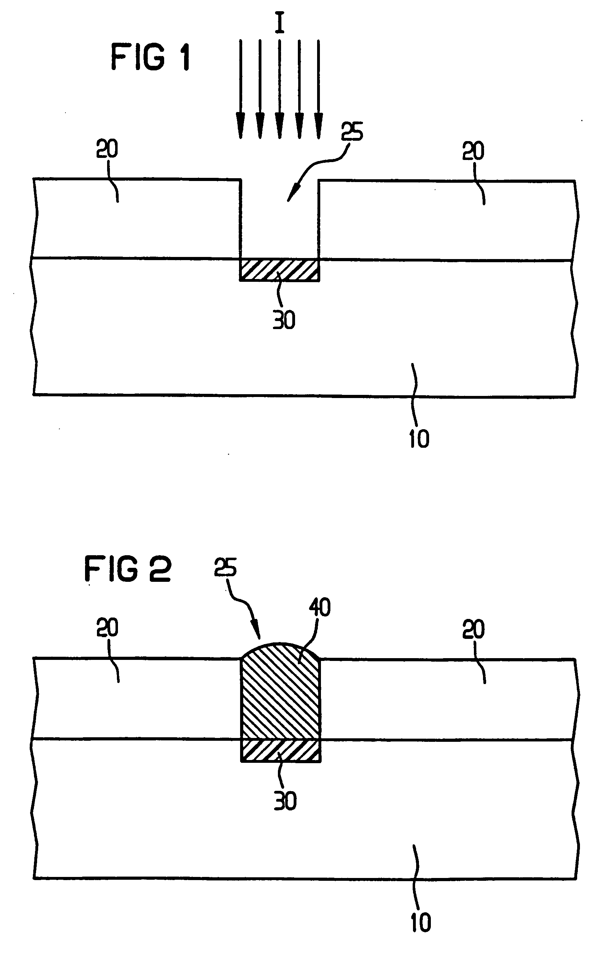

Fig. 1 ist eine schematische Darstellung eines Herstellungsschritts eines Halbleiterspeicherelements der Halbleiter-Speichervorrichtung gemäß einer ersten Ausführungsform der vorliegenden Erfindung.

In Fig. 1 bezeichnen 10 ein Substrat, 20 eine Isolierschicht, 25 ein Kontaktloch, 30 einen Bitfestlegungsbereich, 40 einen Kontaktstöpselbereich und I eine Implantation.

Das Verfahren zum Herstellen der erfindungsgemäßen Halbleiter-Speichervorrichtung gemäß dieser ersten Ausführungsform verläuft folgendermaßen.

Das Substrat 10 mit dem ersten Leitungstyp (z.B. n-Silizium) wird bereitgestellt. Dabei soll der Ausdruck Substrat im allgemeinen Sinne verstanden werden, muß also nicht der physikalische Träger sein, sondern kann auch eine darauf befindliche Epischicht, ein darin vorgesehener Diffusionsbereich o.ä. sein.

Als nächstes erfolgt das Vorsehen der Isolierschicht 20 auf dem Substrat 10, in der eine Matrix von Kontaktlöchern 25 zum Substrat 10 entsprechend jeweiligen Halbleiterspeicherelementen zu bilden ist.

Zur Programmierung der so definierten Halbleiterspeicherelemente wird nach der Bildung der jeweiligen Kontaktlöcher 25 der unterhalb der Kontaktlöcher 25 befindliche Oberflächenbereichs des Substrats 10 mit einem jeweiligen Kontaktwiderstand entsprechend dem in dem jeweiligen Halbleiterspeicherelement zu speichernden Bit als Bitfestlegungsbereich 30 des betreffenden Halbleiterspeicherelements versehen.

Dies geschieht im vorliegenden Beispiel folgendermaßen.

Alle Kontaktlöcher 25 werden photolithographisch definiert und freigeätzt. Dann erfolgt das Durchführen der ersten Implantation I in diese erste Gruppe von Kontaktlöchern 25 mit einem Dotierstoff des ersten Leitungstyps n.

Dann erfolgt das Durchführen einer zweiten Implantation mit einem Dotierstoff des zweiten Leitungstyps p.

Die dritte Gruppe von Kontaktlöchern 25 bleibt während der beiden Implantationen abgedeckt, erhält also keine Implantation.

Es gibt also folgende Halbleiterspeicherzellen mit wachsendem Kontaktwiderstand: Kontaktimplantation wie darunterliegendes Substrat (z.B. wie Diffusionsimplantation), keine Implantation und Kontaktimplantation entgegengesetzt zum darunterliegenden Substrat, wobei Fig. 1 nur den ersten Fall zeigt.

So lassen sich pro zwei Speicherzellen drei Bits programmieren. Denkbar ist auch eine Anwendung in einer dreiwertigen Logikschaltungsvorrichtung (ternäres System).

Fig. 2 ist eine schematische Darstellung eines weiteren Herstellungsschritts des Halbleiterspeicherelements der Halbleiter-Speichervorrichtung gemäß der ersten Ausführungsform der vorliegenden Erfindung.

In Fig. 2 bezeichnet zusätzlich zu den bereits eingeführten Bezugszeichen 40 einen Kontaktstöpsel.

Nach Programmierung der jeweiligen Halbleiterspeicherelemente werden Kontaktstöpsel 40 in den Kontaktlöchern 25, die in elektrischem Kontakt mit dem Bitfestlegungsbereich 30 stehen, vorgesehen.

Zweckmäßigerweise weist der Substratbereich 10 eine streifenförmige Leiterstreifen-Struktur auf, z.B. Polysilizium- oder Diffusionstreifen, wobei diese Streifen jeweils den zweiten Anschluß der Speicherzellen auf der Substratoberseite bilden, der neben dem jeweiligen Kontaktstöpsel 40 einen Anschluß für eine Auswerteschaltung mit einer Widerstandsmeßeinrichtung bildet.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Insbesondere können weitere Implantationen ausgeführt werden, um Halbleiterspeicherelemente zu schaffen, welche noch mehr Logikwerte speichern können. So ermöglicht die vorliegende Erfindung die Herstellung eines kostengünstigen Multi-Level-ROMs durch Anwendung der ohnehin vorhandenen Kontaktlochimplantation(en) zur Programmierung.

## Patentansprüche

1. Halbleiter-Speichervorrichtung mit einer Matrix von in einem Substrat (10) angeordneten Halbleiterspeicherelementen, welche aufweist:
ein Halbleitersubstrat (10) mit einem ersten Leitungstyp;
eine auf dem Halbleitersubstrat (10) vorgesehene Isolierschicht (20);
ein für jedes Halbleiterspeicherelement in der Isolierschicht (20) vorgesehenes Kontaktloch (25);
einen im Halbleitersubstrat (10) unterhalb des jeweiligen Kontaktlochs (25) vorgesehenen Bitfestlegungsbereich (30);
einen im jeweiligen Kontaktloch (25) vorgesehenen, in elektrischem Kontakt mit dem Bitfestlegungsbereich (30) stehenden Kontaktstöpsel (40);
einen im Halbleitersubstrat (10) außerhalb des Bitfestlegungsbereichs (30) vorgesehenen weiteren Kontaktbereich;
wobei der Bitfestlegungsbereich (30) derart gestaltet ist, dass der Kontaktwiderstand zwischen dem Halbleitersubstrat (10) und dem jeweiligen Kontaktstöpsel (40) das in dem jeweiligen Halbleiterspeicherelement zu speichernde Bit festlegt;
und eine Auswerteschaltungseinrichtung zum Auswerten des Kontaktwiderstandes der jeweiligen Halbleiterspeicherelemente;
wobei der Bitfestlegungsbereich (30) bei einer ersten Gruppe der Halbleiterspeicherelemente ein an der Oberfläche des Substrats (10) gelegener Implantationsbereich mit einem Dotierstoff des ersten Leitungstyps zur Erniedrigung des Kontaktwiderstands ist;
der Bitfestlegungsbereich (30) bei einer zweiten Gruppe der Halbleiterspeicherelemente ein an der Oberfläche des Substrats (10) gelegener Implantationsbereich mit einem Dotierstoff des zweiten Leitungstyps zur Erhöhung des Kontaktwiderstands ist; und
der Bitfestlegungsbereich (30) bei einer dritten Gruppe der Halbleiterspeicherelemente ein an der Oberfläche des Substrats (10) gelegener Bereich ist, dessen Dotierung dem Halbleitersubstrat (10) entspricht.

2. Verfahren zum Herstellen einer Halbleiter-Speichervorrichtung, mit den Schritten
a) Bereitstellen eines Halbleitersubstrats (10) mit einem ersten Leitungstyp;
b) Vorsehen einer Isolierschicht (20) auf dem Halbleitersubstrat (10);
c) Vorsehen einer Matrix von Kontaktlöchern (25) zum Halbleitersubstrat (10) in der Isolierschicht (20) entsprechend jeweiligen Halbleiterspeicherelementen;
d) Versehen des unterhalb der jeweiligen Kontaktlöcher (25) befindlichen Oberflächenbereichs des Halbleitersubstrats (10) mit einem jeweiligen Kontaktwiderstand entsprechend dem in dem jeweiligen Halbleiterspeicherelement zu speichernden Bit als Bitfestlegungsbereich (30) des betreffenden Halbleiterspeicherelements;
e) Vorsehen von Kontaktstöpseln (40) in den Kontaktlöchern (25), die in elektrischem Kontakt mit dem Bitfestlegungsbereich (30) stehen; und
f) Vorsehen eines im Halbleitersubstrat (10) außerhalb des Bitfestlegungsbereichs (30) gelegenen weiteren Kontaktbereichs;
g) Durchführen einer ersten Implantation mit einem Dotierstoff des ersten Leitungstyps in eine erste Gruppe von Kontaktlöchern (25) unter Maskierung der übrigen Kontaktlöcher (25);
h) Durchführen einer zweiten Implantation mit einem Dotierstoff des zweiten Leitungstyps in eine zweite Gruppe von Kontaktlöchern (25) unter Maskierung der übrigen Kontaktlöcher (25); und
i) Belassen der Substratdotierung im unterhalb der jeweiligen Kontaktlöcher (25) befindlichen Oberflächenbereich des Halbleitersubstrats (10) bei einer dritten Gruppe von Kontaktlöchern.

## Claims

1. Semiconductor memory device having a matrix of semiconductor memory elements arranged in a substrate (10), which has:
a semiconductor substrate (10) having a first conduction type;
an insulating layer (20) provided on the semiconductor substrate (10);
a contact hole (25) provided for each semiconductor memory element in the insulating layer (20);
a bit definition region (30) provided in the semiconductor substrate (10) underneath the respective contact hole (25);
a contact plug (40), which is provided in the respective contact hole (25) and is in electrical contact with the bit definition region (30);
a further contact region provided in the semiconductor substrate (10) outside the bit definition region (30);
the bit definition region (30) being configured in such a way that the contact resistance between the semiconductor substrate (10) and the respective contact plug (40) defines the bit to be stored in the respective semiconductor memory element;
and an evaluation circuit device for evaluating the contact resistance of the respective semiconductor memory elements;
wherein the bit definition region (30) in a first group of the semiconductor memory elements is an implantation region which is located at the surface of the substrate (10) and has a dopant of the first conduction type for decreasing the contact resistance;
the bit definition region (30) in a second group of the semiconductor memory elements is an implantation region which is located at the surface of the substrate (10) and has a dopant of the second conduction type for increasing the contact resistance; and
the bit definition region (30) in a third group of the semiconductor memory elements is a region which is located at the surface of the substrate (10) and whose doping corresponds to the semiconductor substrate (10).

2. Method for fabricating a semiconductor memory device, having the following steps:
a) provision of a semiconductor substrate (10) having a first conduction type;
b) provision of an insulating layer (20) on the semiconductor substrate (10);
c) provision of a matrix of contact holes (25) to the semiconductor substrate (10) in the insulating layer (20) in accordance with respective semiconductor memory elements;
d) provision of that surface region of the semiconductor substrate (10) which is situated underneath the respective contact holes (25) with a respective contact resistance in accordance with the bit to be stored in the respective semiconductor memory element as bit definition region (30) of the relevant semiconductor memory element;
e) provision of contact plugs (40) in the contact holes (25), which are in electrical contact with the bit definition region (30); and
f) provision of a further contact region located in the semiconductor substrate (10) outside the bit definition region (30);
g) performance of a first implantation with a dopant of the first conduction type into a first group of contact holes (25) with the remaining contact holes (25) being masked;
h) performance of a second implantation with a dopant of the second conduction type into a second group of contact holes (25) with the remaining contact holes (25) being masked; and
i) leaving the substrate doping in that surface region of the semiconductor substrate (10) which is situated underneath the respective contact holes (25) in a third group of contact holes.

## Revendications

1. Dispositif de mémoire semi-conducteur comprenant une matrice de composants de mémoire semi-conducteur disposés sur un substrat (10), lequel comprend :
un substrat semi-conducteur (10) avec une première nature de conductivité ;
une couche isolante (20) prévue sur le substrat semi-conducteur (10) ;
un trou de contact (25) prévu pour chaque composant de mémoire semi-conducteur dans la couche isolante (20);
une zone d'affectation de bit (30) prévue au-dessous du trou de contact (25) correspondant dans le substrat semi-conducteur (10) ;
un bouchon de contact (40) en contact électrique avec la zone d'affectation de bit (30) et prévu dans le trou de contact (25) correspondant ;
une autre zone de contact prévue dans le substrat semi-conducteur (10) à l'extérieur de la zone d'affectation de bit (30) ;
dans lequel la zone d'affectation de bit (30) est configurée de telle façon que la résistance de contact entre le substrat semi-conducteur (10) et le bouchon de contact (40) correspondant fixe le bit à mémoriser dans le composant mémoire semi-conducteur correspondant ;
et un circuit d'évaluation pour l'évaluation de la résistance de contact des composants mémoire semi-conducteur correspondants ;
dans lequel la zone d'affection de bit (30) est, dans un premier groupe de composants mémoire semi-conducteur, une zone d'implantation située à la surface du substrat (10) avec un dopant de première nature de conductivité pour réduire la résistance de contact ;
la zone d'affection de bit (30) est, dans un deuxième groupe de composants mémoire semi-conducteur, une zone d'implantation située à la surface du substrat (10) avec un dopant de deuxième nature de conductivité pour augmenter la résistance de contact ; et
la zone d'affection de bit (30) est, dans un troisième groupe de composants mémoire semi-conducteur, une zone située à la surface du substrat (10) dont le dopage correspond au substrat semi-conducteur (10).

2. Procédé pour la réalisation d'un dispositif mémoire semi-conducteur avec les étapes :
a) Mise à disposition d'un substrat semi-conducteur (10) avec une première nature de conductivité ;
b) Prévision d'une couche isolante (20) sur le substrat semi-conducteur (10) ;
c) Prévision d'une matrice de trous de contacts (25) vers le substrat semi-conducteur (10) dans la couche isolante (20) correspondant à chaque fois aux composants mémoires semi-conducteurs ;
d) Prévision de la zone de surface sur le substrat semi-conducteur (10) se trouvant au-dessous des trous de contact correspondants (25) avec une résistance de contact correspondante qui correspond au bit à mémoriser dans le composant mémoire semi-conducteur correspondant comme zone d'affectation de bit (30) du composant mémoire semi-conducteur concerné ;
e) Prévision de bouchons de contact (40) dans les trous de contact (25) étant en contact électrique avec la zone d'affectation de bit (30) ; et
f) Prévision d'une autre zone de contact dans le substrat (10) située à l'extérieur de la zone d'affectation de bit (30) ;
g) Réalisation d'une première implantation avec un dopant de première nature de conductivité dans un premier groupe de trous de contact (25) en masquant les autres trous de contact (25) ;
h) Réalisation d'une deuxième implantation avec un dopant de deuxième nature de conductivité dans un deuxième groupe de trous de contact (25) en masquant les autres trous de contact (25) ; et
i) Maintient, dans un troisième groupe de trous de contact, du dopage du substrat dans la zone de surface du substrat semi-conducteur (10) se trouvant au-dessous des trous de contact correspondants (25).
